## Europäisches Patentamt

(19) **European Patent Office**

**Office européen des brevets**

(11) Veröffentlichungsnummer: **0 140 126**

**B1**

(12) **EUROPÄISCHE PATENTSCHRIFT**

(45) Veröffentlichungstag der Patentschrift:
04.01.89

(21) Anmeldenummer: **84111126.3**

(22) Anmeldetag: **18.09.84**

(51) Int. Cl.⁴: **H 01 L 21/60**

(54) Verfahren zur Mikropackherstellung.

(30) Priorität: **07.10.83 DE 3336606**

(43) Veröffentlichungstag der Anmeldung:
**06.05.85 Patentblatt 85/19**

(45) Bekanntmachung des Hinweises auf die Patenterteilung:
**04.01.89 Patentblatt 89/1**

(84) Benannte Vertragsstaaten:
**AT DE FR GB IT**

(56) Entgegenhaltungen:
**FR-A-2 295 569**

**PATENT ABSTRACTS OF JAPAN Band 6, Nr. 234, 20. November 1982, Seite (E-143)(1112); & JP-A-57-136341 (HITACHI) 23-08-1982 ° Zusammenfassung ° ELECTRONICS, Band 48, Nr. 26, 25. Dezember 1975, New York, USA; J. LYMAN "Special Report : Film Carriers Star in High Volume IC Production", Seiten 61-68**

(73) Patentinhaber: **Siemens Aktiengesellschaft Berlin und München, Wittelsbacherplatz 2, D-8000 München 2 (DE)**

(72) Erfinder: **Wilde, Rüdiger, Züricher Strasse 186, D-8000 München 71 (DE)**

**Beschreibung**

Die Erfindung betrifft ein Verfahren zur Mikropackherstellung durch Verlöten von Chips eines Wafers mit auf einem Trägerstreifen aufgebrachten Anschlußbahnen.

Bei der Mikropackherstellung werden Folien auf einem Streifenträger, beispielsweise aus einem Filmmaterial, aufgebracht und partiell so verzinnt, daß durch einen Ätzvorgang Anschlüsse für die Chip-Innenlötung sowie für die Außenlötung auf einer Leiterplatte entstehen. Auf der Chip-Oberseite befinden sich gut lötbare Höcker, die durch einen Wärmeimpuls in den Trägerstreifen eingelötet werden. Bei den Verfahrensschritten, welche den Weg des Chips vom Wafer bis zum Auflöten auf den Streifenträger betreffen, muß berücksichtigt werden, daß die Chips einerseits nur geringe Größe aufweisen, sehr empfindlich gegenüber mechanischen und thermischen Einwirkungen sind und andererseits in einer großen Stückzahl anfallen. Das macht es erforderlich, daß während der Herstellung jeder Zugriff auf einen Chip sehr präzise erfolgen muß, d.h. daß aufwendige Justierungen durchzuführen sind, und daß die Belastungen für den Schaltkreis niedrig zu halten sind.

Aus der Zeitschrift Electronics, Bd. 48, Nr. 26, S. 61 bis 68, ist ein Verfahren zur Mikropackherstellung bekannt, bei dem ein Wafer mittels eines Haftmittels auf ein Glassubstrat aufgebracht wird, mit dessen Hilfe eine Planlage gewährleistet wird. Dann wird der Wafer zum Vereinzeln von Chips zerteilt und danach die Löthöcker eines Chips gegen auf einem Trägerstreifen aufgebrachte zu verlötende Anschlußbahnen ausgerichtet. Anschliessend werden Lötverbindungen mit Hilfe eines Lötstempels hergestellt und eine Trennung des verlöteten Chips vom Substrat dadurch vorgenommen, daß das Haftmittel gleichzeitig mit dem Lötvorgang aufgeschmolzen wird und dann das Substrat mit den darauf verbleibenden restlichen Chips vom verlöteten Chip weggeführt wird.

Dieses Verfahren hat erhebliche Nachteile. Die zum Kleberaufweichen notwendige Temperatur wird beim Lötvorgang über die jeweils vorhandene Anzahl der Löthöcker des Chips übertragen. Daraus folgt, daß die Löttemperatur weitgehend auf die Erfordernisse zum Aufschmelzen des Klebers abgestimmt werden muß. Die für dieses Verfahren notwendigen Temperaturen liegen folglich weit über der zum eigentlichen Löten erforderlichen Temperatur. Einerseits ergibt sich durch diese für den eigentlichen Lötvorgang zu hohen Temperaturen keine homogene und metallurgisch einwandfreie Zinnschicht zwischen Höckeroberseite und Anschlußbahnen. Andererseits ergibt sich eine erhebliche thermische Belastung des Chips, die durch die Wärmeübertragung von den Löthöckern auf die Chiprückseite gegeben ist. Wegen der hohen Temperaturen verbleiben nach dem Abheben des Chips erhebliche Kleberrückstände auf der Chiprückseite, und auf der Chipvorderseite können durch den verflüssigten Kleber partielle Verunreinigungen entstehen. Das Problem besteht darin, daß beim Anheben des Chips die Zinn-Erstarrungstemperatur bereits erreicht sein muß, andererseits die durch den wiedererkaltenden Kleber entstehende Klebekraft von den Anschlußbahnen aufgenommen werden muß, die sich aber nicht verbiegen sollen.

Der Erfindung lag daher die Aufgabe zugrunde, ein Verfahren der obengenannten Art anzugeben, das sich durch optimierte Verfahrensschritte auszeichnet, wobei die mechanische und thermische Belastung äußerst gering ist.

Diese Aufgabe wird durch die im Patentanspruch 1 angegebenen Verfahrensschritte gelöst.

Die Erfindung hat den Vorteil, daß die Löttemperatur optimal auf den Lötprozess abgestimmt werden kann. Verunreinigungen durch Kleberrückstände entfallen weil beim Abheben des Chips die haftende Schift auf dem ersten Träger verbleibt. Eine nachfolgend Reinigung von Kleberresten kann somit entfallen.

Weiterbildungen der Erfindung ergeben sich aus den Unteransprüchen.

Im folgenden wird die Erfindung anhand eines Ausführungsbeispieles beschreiben.

Fig. 1    zeigt schematisch eine Draufsicht auf einen flächigen Chipträger und auf einen Trägerstreifen,

Fig. 2    bis 5 zeigen abschnittsweise den Verlauf des Verfahrens.

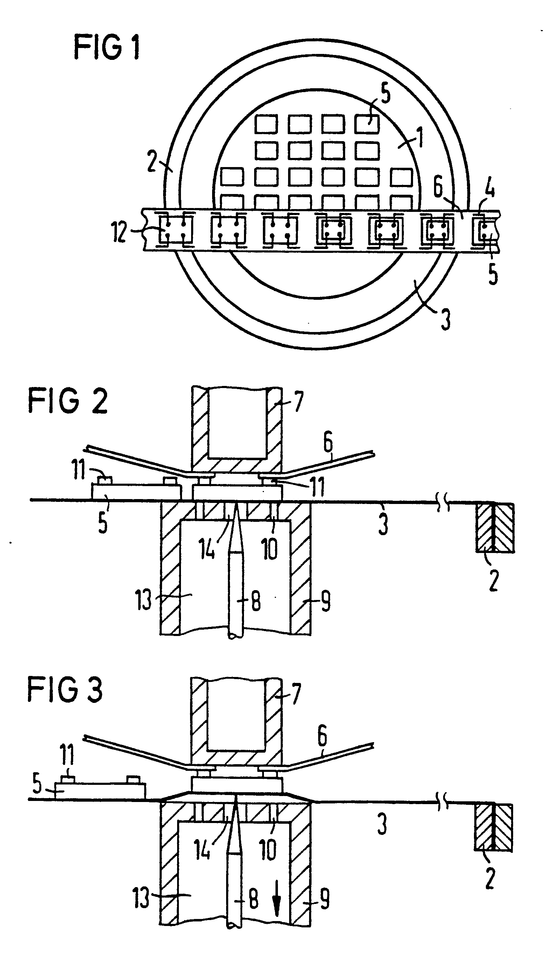

Wie Fig. 1 zeigt, wird ein Wafer 1 auf einen flächigen, ersten Träger 3 aufgebracht, der in einen Spannring 2 fest eingespannt ist. Der Träger 3 besteht aus einem folienartigen Material, welches an seiner Oberfläche ein Klebemittel aufweist, das dazu dient, den Wafer 1 zu halten. Diese Haftschicht besteht beispielsweise aus einem elektrisch leitenden Klebstoff. Ferner ist der Träger 3 zumindest kurzzeitig löttemperaturbeständig, so daß eine Lötung zerstörungsfrei durchgeführt werden kann. Die Festigkeit des Trägers 3 ist so, daß er von einem spitzen Dorn durchdringbar ist. Alle diese Eigenschaften weist beispielsweise eine Polyimidfolie auf.

In einem zweiten Verfahrensschritt wird der Wafer 1 durch Zersägen zerteilt, so daß die Chips 5 einzeln auf dem ersten Träger 3 haften. Anschließend werden der Träger 3 und ein streifenförmiger Träger 6 mit aufgebrachten Anschlußbahnen 4, relativ zueinander so ausgerichtet, daß bezüglich eines Chips Lötverbindungen zwischen Löthöckern 11 auf dem Chip 5 und den freien Enden der Anschlußbahnen 4 auf dem Träger 6 herstellbar sind. Dies Anschlußbahnen 4 ragen in Aussparungen 12 des Trägerstreifens 6, welche zur Aufnahme von Chips 5 vorgesehen sind.

In dem folgenden, in Fig. 2 gezeigten Verfahrensschnitt wird unterhalb des Chips 5, auf dessen Löthöcker die Lötanschlüsse ausgerichtet sind, ein Stempel 9 mit dem ersten Träger 3 in Berührung gebracht. die Berührungsfläche des Stempels 9 ist mit Durchbröchen 10 versehen, welche in einen Hohlraum in Innern des Stempels 9 führen. Dieser Hohlraum 13 wird mit einen Vakuum beaufschlagt, welches bewirkt, daß der Träger 3 fest an den Stempel 9 gepreßt wird. Auf die gegenüberliegende Seite des Chips 5 wird ein Lötstempel 7 gebracht, mit welchem mittels Wärmeimpulsen Lötverbindungen zwischen den Höckern 11 und den Bahnen 7 hergestellt wenden.

Innerhalb des Stempels 9 ist ein Dorn 8 angebracht, dessen Spitze durch eine weitere Öffnung 14 im Stempel 9 auf die Chiprückseite gerichtet ist.

Nach dem Erkalten der Lötstelle wird gemäß Fig. 3 der Stempel 9 zusammen mit dem angesaugten Träger 3 von den Lötstempel 7 in Pfeilrichtung wegbewegt. Der Dorn 8 verändert seine Lage dabei nicht.

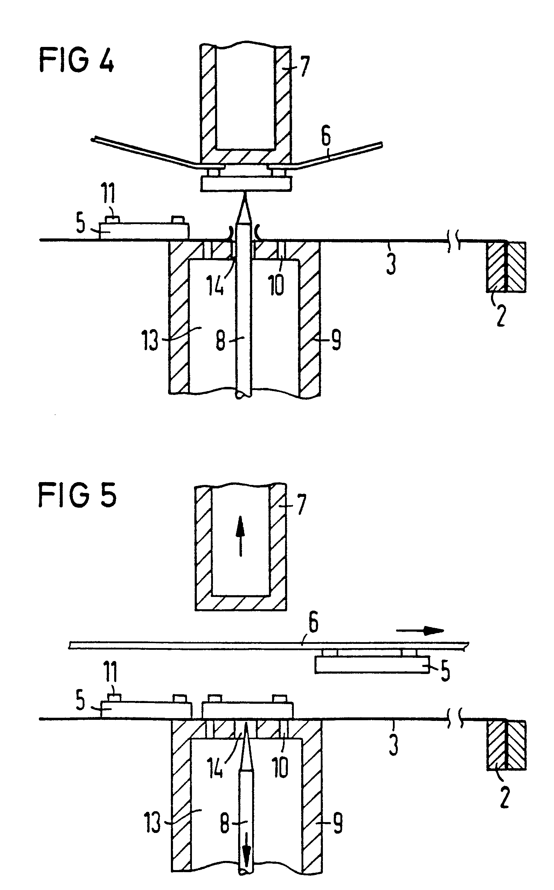

Durch diese Relativbewegung zwischen den Träger 3 und den senkrecht dazu verlaufenden Dorn 8 durchstößt die Spitze des Dorns 8 den Träger 3. Fig. 4 zeigt, wie dadurch der Chip 5 von den Träger 4 gelöst wird, wobei er durch den Druck zwischen dem Dorn 8 und dem Lötstempel 7 in seiner Lage fixiert ist.

Fig. 5 zeigt, wie nach dem Ablösen ‚des Chips 5 von Träger ein Hub des Lötstempels 7 in Pfeilrichtung erfolgt und wie der Dorn 8 abgesenkt wird. Abschließend erfolgt ein Vorschub des Trägerstreifens 6 in Pfeilrichtung.

**Patentansprüche**

1. Verfahren zur Mikropackherstellung durch Verlöten von Chips (5) eines Wafers (1) mit auf einem Trägerstreifen (6) aufgebrachten Anschlußbahnen (4), wobei die nachfolgenden Verfahrensschritte vorgesehen sind:
- Aufkleben des Wafers (1) auf einen aus einem durchdringbaren folienartigen Material bestehenden Träger (3) mit Hilfe eines zumindest kurzzeitig lottemperaturabeständigen Haftmittels,
- Zerteilen des Wafers (1) zum Vereinzeln der Chips (5),
- Ausrichten der einem Chip (5) auf dem Trägerstreifen (6) zugeordneten Lötanschlüsse der Anschlußbahnen (4) auf entsprechende Löthöcker (11) des Chips (5),
- Anpressen des Trägers (3) unterhalb des Chips (5) an die Oberfläche eines herangeführten Stempels (9) mit einer Öffnung (14), durch die ein Dorn (8) auf die Chiprückseite gerichtet wird,
- Absenken eines Lötstempels (7) gegen die Vorderseite des Chips,
- Herstellen von Lötverbindungen mittels einer auf den Lötprozeß abgestimmten Löttemperatur,
- Durchstoßen des Trägers (3) und Abheben des Chips (5) vom Träger (3) mittels einer Relativbewegung zwischen dem Dorn (8) und dem Träger (3),
- Hub des Lötstempels (7) und Absenken des Dorns (8).

2. Verfahren nach Anspruch 1, <u>dadurch gekennzeichnet</u>, daß während der Relativbewegung der folienartige Träger (3) plan gehalten wird.

3. Verfahren nach Anspruch 2, <u>dadurch gekennzeichnet</u>, daß der folienartige Träger während der Relativbewegung mittels Unterdruck an einer planen Fläche gehalten wird.

4. Verfahren nach einem der vorhergehenden Ansprüche, <u>dadurch gekennzeichnet</u>, daß als folienartiger Träger (3) eine mit Silikonkleber beschichtete Polyimidfolie verwendet wird.

**Claims**

1. Method of tape-automated bonding by means of soldering chips (5) of a wafer (1) to connection tracks (4) placed on a carrier tape (6), the following method steps being envisaged:
- bonding the wafer (1) to a carrier (3) consisting of a permeable film-like material with the aid of an adhesive which is soldering temperature-resistant at least for a short time,
- division of the wafer (1) for separation of the chips (5),
- alignment of the soldering terminals, assigned to a chip (5) on the carrier tape (6), of the connection tracks (4) to corresponding solder bumps (11) of the chip (5),
- pressing the carrier (3) beneath the chip (5) against the surface of a stamp (9) brought up, said stamp having an opening (14) through which a spike (8) is directed towards the rear of the chip,
- lovering of a soldering stamp (7) against the front side of the chip,
- creation of soldering connections by means of a soldering temperature matched to the soldering process,
- penetration of the carrier (3) and raising of the chip (5) from the carrier (3) by means of a relative movement between the spike (8) and the carrier (3),
- lift of the soldering stamp (7) and lovering of the spike (8).

2. Method according to Claim 1, characterized in that the film-like carrier (3) is held plane during the relative movement.

3. Method according to Claim 2, characterized in that the film-like carrier is held against a plane surface by means of negative pressure during the relative movement.

4. Method according to one of the preceding Claims, characterized in that a polyimide film coated with silicon adhesive is used as the film-like carrier (3).

**Revendications**

1. Procédé de microconditionnement par soudage de pastilles (5) d'une tranche (de silicium) (1) à des pistes de connexion (4) disposées sur une bande de support (6), comprenant les opérations suivantes:
- collage de la tranche (1) sur un support (3) fait d'un matériau semblable à une feuille transperçable, à l'aide d'un adhésif qui résiste au moins brièvement à la température de soudage,
- découpage de la tranche (1) en pastilles (5) séparees,
- alignement des connexions à souder, coordonnées à une pastille (5) sur la bande de support (6) et faisant partie des pistes de connexion (4), sur des protubérances de soudage (11) correspondantes de la pastille (5),
- pressage du support (3) sous la pastille (5) contre le dessus d'un poinçon (9) amené à cet endroit, poinçon qui présente une ouverture (14) à travers de laquelle une broche (8) est dirigée sur le côté arrière de la pastille,
- abaissement d'un poinçon de soudage (7) contre le côté avant de la pastille,
- établissement de liaisons soudées au moyen d'une température de soudage accordée au processus de soudage,
- transpercement du support (3) et soulèvement de la pastille (5) du support (3) au moyen d'un mouvement relatif entre la broche (8) et le support (3) et
- soulèvement du poinçon de soudage (7) et abaissement de la broche (8).

2. Procédé selon la revendication 1, caractérisé en ce que le support (3) semblable à une feuille est maintenu plan pendant le mouvement relatif.

3. Procédé selon la revendication 2, caractérisé en ce que le support semblable à une feuille est maintenu contre une surface plane par une dépression pendant le mouvement relatif.

4. Procédé selon une des revendications précédentes, caractérisé en ce que, comme support (3) semblable à une feuille, on utilise une feuille de polyimide enduite de colle silicone.

## FIG 1

## FIG 2

## FIG 3

1

FIG 4

FIG 5